# EUROPEAN PATENT SPECIFICATION

(11) **EP 0 661 757 B1**
(45) Date of publication and mention of the grant of the patent: **12.06.2002**
(21) Application number: 95200566.8
(22) Date of filing: 06.03.1992
(51) Int. Cl.: H01L 31/0232, H01L 31/0216, H01L 27/146

(54) **Solid-state imaging device and method of manufacturing the same**
Festkörper-Bildaufnahme-Vorrichtung und deren Herstellungsmethode
Dispositif d'imagerie à l'état solide et sa méthode de fabrication

(30) Priority: 06.03.1991 JP 3998991; 06.03.1991 JP 3999091
(43) Date of publication of application: 05.07.1995
(62) Divisional of application: 92301937.6
(73) Proprietor: MATSUSHITA ELECTRIC INDUSTRIAL CO., LTD., Kadoma-shi, Osaka (JP)
(72) Inventor: Nomura, Toru, Takatsuki-shi, Osaka 569 (JP)
(74) Representative: Crawford, Andrew Birkby

(56) References cited:
- EP-A- 0 441 594
- PATENT ABSTRACTS OF JAPAN vol. 009, no. 181 (E-331), 26 July 1985 & JP 60 053073 A (HITACHI SEISAKUSHO KK), 26 March 1985,
- A.K. WEISS ET AL.: "Microlenticular Arrays for Solid-State Imagers" EXTENDED ABSTRACTS, vol. 86-1, no. 1, May 1986, PENNINGTON, NEW JERSEY, US, page 407 XP002051733

## Description

### BACKGROUND OF THE INVENTION

### Field of the Invention

The present invention relates to a solid-state imaging device furnished with a filter having a microlens, and a method of manufacturing the same.

### Prior Art

As the method of fabricating a color solid-state imaging device, recently, methods of forming a color filter directly on the substrate on which the solid-state imaging device is formed are in the mainstream. Furthermore, with the purpose of enhancing the sensitivity of the solid-state imaging device itself, in order to focus light on each light sensing part, a microlens is formed on the color filter layer at the position corresponding to each light sensing part. It is formed by using a negative type material made of protein material such as gelatin and casein provided with photosensitive property, or recently a synthetic material possessing a property of forming a lens shape by melt-flow with heat.

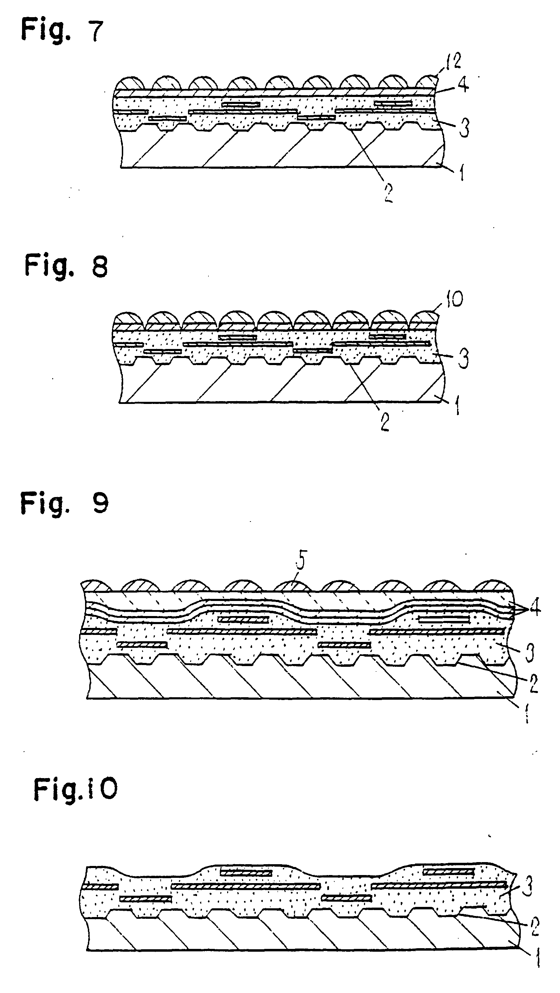

The conventional solid-state imaging device and its manufacturing method are described herein while referring to drawings. Fig. 9 is a partial cross section showing the structure of a conventional solid-state imaging device. Figs. 10 to 14 are partial cross sections showing the manufacturing method of the conventional solid-state imaging device in the sequence of processes.

First, the structure of the solid-state imaging device with a color filter having microlens in the prior art is explained while referring to Fig. 9.

A color filter layer 3 is formed on a solid-state imaging device substrate 1 at a position corresponding to each light sensing part 2 for receiving an incident light. The surface asperities on the color filter layer 3 are smoothed by a transparent material layers 4. On the smoothed surface of the uppermost transparent material layer 4, plural microlenses 5 are formed corresponding to each light sensing part 2, so that the incident light may be focused into each light sensing part 2.

Its operation is as follows.

The light entering the microlenses 5 is focused by the lens effect of the microlens 5. The focused light passes through the color filter layer 3, and is separated into colors to enter respective light sensing parts 2, thereby operating as the solid-state imaging device for obtaining a color pictorial image. In such a structure and an operation, the solid-state imaging device with a color filter having microlens is realized.

In Figs. 10 to 14, the manufacturing method of the conventional solid-state imaging device is described.

Fig. 10 shows the state of forming the color filter layer 3 corresponding to each light sensing part 2 of the solid-state imaging device 1. In Fig. 11, a transparent material layer 4 is applied plural times (three times in this example), and the surface asperities of the color filter layer 3 are smoothed. In succession, in Fig. 12, a photosensitive material layer 6 is formed above the color filter layer 3 of which surface has been smoothed by the transparent material layer 4. In Fig. 13, consequently, the photosensitive material layer 6 is processed by selective exposure by means of a mask (not shown) and development, thereby forming a photosensitive material patterns 7. Finally, in Fig. 14, by heating and melting the photosensitive material patterns 7, a microlens 5 is formed. Thus, the solid-state imaging device with a color filter having microlens is realized.

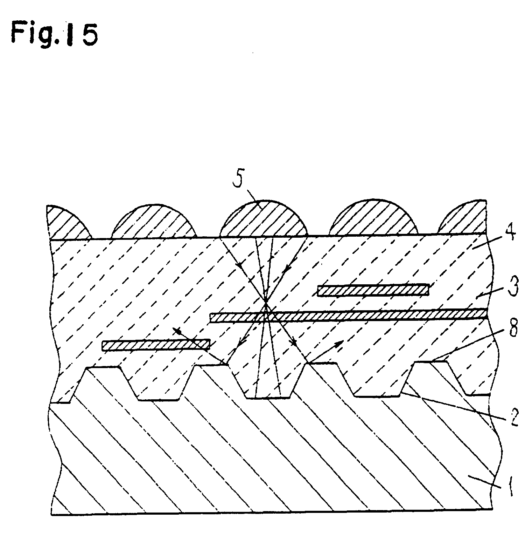

In such a conventional constitution, however, the color filter surface asperities are smoothed by forming the transparent material layer plural times, and the microlens layer is formed thereon. Therefore, the distance between the microlens and the light sensing parts is long, and the light sensitivity of the solid-state imaging device deteriorates. This mechanism is closely described below while referring to the drawing. Fig. 15 is a partial magnified cross section showing the mechanism of focus deviation of the solid-state imaging device in the prior art.

The color filter layer 3 is formed on the light sensing parts 2 and charge transfer parts 8 of the substrate 1. The surface asperities of the color filter layer 3 are smoothed by forming the transparent material layer 4 plural times. Further on it, the microlenses 5 are formed corresponding to each light sensing part 2. In this case, due to the thickness of the transparent material layer 4 for smoothing the surface asperities of the color filter layer 3, the distance from the microlenses 5 to the light sensing parts 2 becomes long, and the focal length is deviated. When the focal length is deviated, the light focused by the microlens 5 loses its focusing property and scatters, and the quantity of incident light to the light sensing parts 2 decreases. As a result, the light sensitivity of the solid-state imaging device is lowered, and the light sensitivity on the image characteristic also becomes poor. If attempted to form a microlens adjusted to the focal length, as the focal length becomes longer, the radius of curvature of the microlens becomes larger, and it means there is no other choice than to form a microlens low in the focusing density. Henceforth, however, as the solid-state imaging device is further downsized, and accordingly, the size of microlens must be shrinked, the light sensitivity becomes poorer.
It is hence indispensable to raise the focusing density by efficiently focusing the incident light into the light sensing parts 2 by the lens effect of the microlens. Besides, as shown in Fig. 15, when the incident light enters the light sensing parts 2 largely off the focus, the incident light scatters, and a part of the light hits against the charge transfer part 8 existing between the light sensing parts 2, and is reflected to enter a neighboring light sensing part 2 other than the intended one. In the neighboring light sensing part 2, since other color signal enters, if such reflection from the charge transfer part 8 increases, it leads to a mixture of colors on the color pictorial image characteristic, which is a major fault.

Concerning the manufacturing method, on the other hand, although the surface asperities of the color filter layer 3 are smoothed by forming the transparent material layer 4 plural times, the transparent material layer 4 is formed only by applying a transparent resin or the like, and it is impossible to flatten by application alone, which is another problem. It may be possible to flatten by increasing the thickness of the coat film or applying four times or five times, but it further causes to extend the distance between the light sensing parts 2 and the microlenses 5, which results in, needless to say, lowering of light sensitivity due to deviation of the focus as shown in Fig. 15. Meanwhile, the step of flattening the color filter layer surface before forming the microlens is indispensable. That is, if the microlenses are formed without flattening the color filter layer surface, uniform microlenses cannot be formed. With the microlenses of nonuniform shape, the light sensitivity fluctuates, which leads to a different problem of uneven sensitivity in an image characteristic.

It is hence a primary object of the invention to present a solid-state imaging device having microlenses for focusing the light entering the solid-state imaging device efficiently into the light sensing parts, and a method of manufacturing the same, in order to solve the above-discussed problems in the prior art.

Patent Abstracts of Japan vol. 009 no 181 (E-331), 26th July 1985 and JP-A-60053073 concerns a microlens layer formed on a solid state imaging device wherein the lower periphery of each microlens contacts the lower periphery of the adjacent microlens. The microlenses are manufactured by etching a transparent material layer using a mask of hemispherically shaped photoresist pattern.

### SUMMARY OF THE INVENTION

According to the invention, on the filter layer on the solid-state imaging device substrate, microlenses made of transparent material layer and photosensitive material layer are formed in a substantial hemisphere shape so as to contact the lower periphery with the lower periphery of the adjacent microlens.

The manufacturing method thereof comprises a step of forming a first layer by forming a transparent material layer on the filter layer formed on the solid-state imaging device substrate, a step of forming a second layer by forming a photosensitive material layer on the first layer and patterning by exposing selectively, a step of fully exposing the patterned photosensitive material layer, a step of forming microlenses by heating and melting the patterned photosensitive material layer after full exposure, and a step of forming a V-groove in the sectional direction by removing the first layer composed of the transparent material layer existing between adjacent microlenses.

By the constitution of the solid-state imaging device of the invention, since plural microlenses are formed continuously without being independent separately, the incident light is focused effectively by the microlenses, and ineffective light is reduced. Therefore, unlike the prior art, deterioration of an image characteristic such as lowering of light sensitivity due to poor focusing property may be eliminated.

In the manufacturing method of the solid-state imaging device of the invention, to form microlenses on the color filter layer, a transparent material layer is formed, a photosensitive material is formed thereon, the photosensitive material layer is patterned by selective exposure, and the photo-sensitive material layer is fully exposed and heated, so that microlenses having a hemisphere shape may be easily formed. By removing the transparent material layer existing between the adjacent microlenses by etching in V-form or the like in the sectional direction, the lower periphery of the microlenses are contact with each other and formed continuously without being independently separately.

### BRIEF DESCRIPTION OF THE DRAWINGS

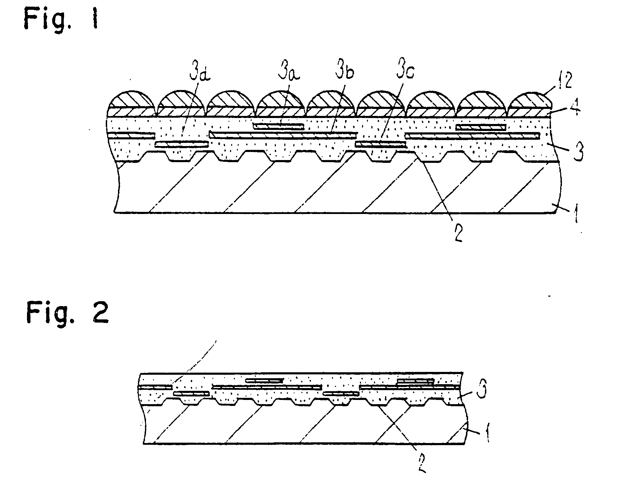

Fig. 1 is a partial cross section showing the constitution of a solid-state imaging device in an embodiment of the invention.

Fig. 2 is a partial cross section showing a first step of the manufacturing method of solid-state imaging device in the embodiment of the invention;

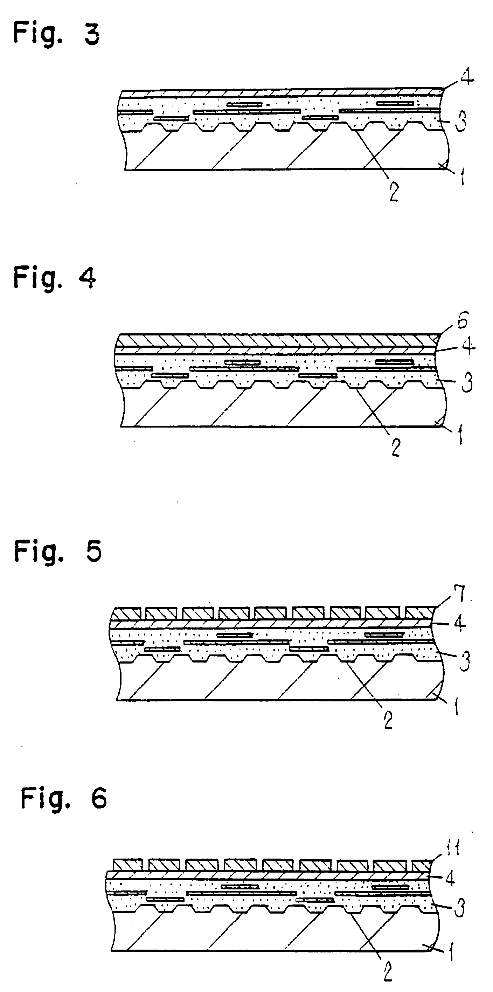

Fig. 3 is a partial cross section showing a second step of the manufacturing method of solid-state imaging device in the embodiment of the invention;

Fig. 4 is a partial cross section showing a third step of the manufacturing method of solid-state imaging device in the embodiment of the invention;

Fig. 5 is a partial cross section showing a fourth step of the manufacturing method of solid-state imaging device in the embodiment of the invention;

Fig. 6 is a partial cross section showing a fifth step of the manufacturing method of solid-state imaging device in the embodiment of the invention;

Fig. 7 is a partial cross section showing the sixth step of the manufacturing method of solid-state imaging device in the embodiment of the invention;

Fig. 8 is a partial cross section showing a seventh step of the manufacturing method of solid-state imaging device in the embodiment of the invention;

Fig. 9 is a partial cross section showing the constitution of a solid-state imaging device in the prior art;

Fig. 10 is a partial cross section showing a first step of the manufacturing method of solid-state imaging device in the prior art;

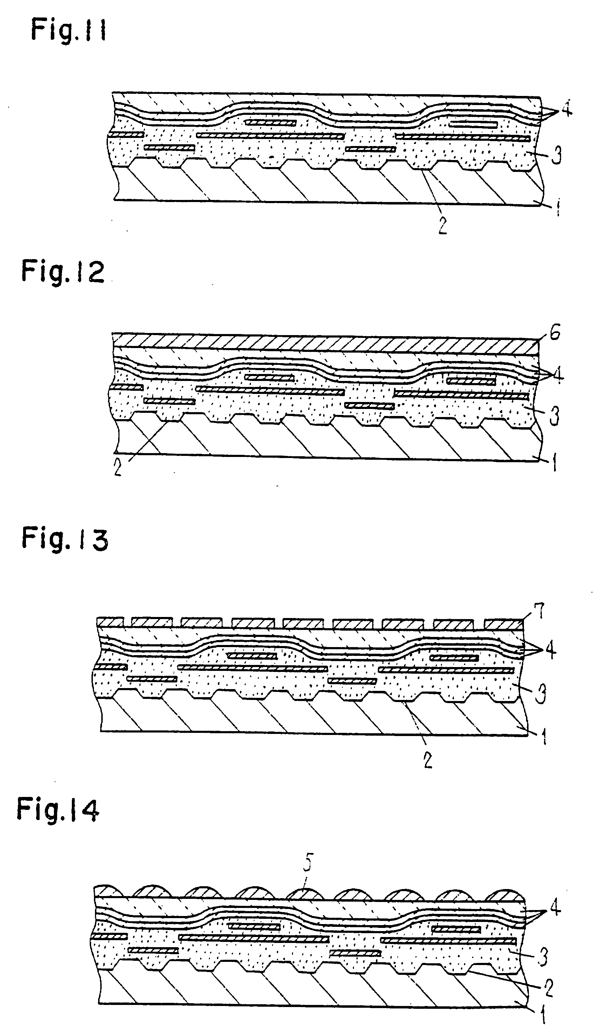

Fig. 11 is a partial cross section showing a second step of the manufacturing method of solid-state imaging device in the prior art;

Fig. 12 is a partial cross section showing a third step of the manufacturing method of solid-state imaging device in the prior art;

Fig. 13 is a partial cross section showing a fourth step of the manufacturing method of solid-state imaging device in the prior art;

Fig. 14 is a partial cross section showing a fifth step of the manufacturing method of solid-state imaging device in the prior art;

Fig. 15 is a partial magnified cross section showing the mechanism of focus deviation in the solid-state imaging device in the prior art.

### DETAILED DESCRIPTION OF THE INVENTION

Referring now to the drawings, an embodiment of the invention is described in detail below.

Fig. 1 is a partial cross section showing the structure of a solid-state imaging device in an embodiment of the invention. Figs. 2 to 8 are partial cross sections showing the manufacturing method of the solid-state imaging device in the embodiment in the sequence of steps.

In Fig. 1, the constitution of the solid-state imaging device in the embodiment of the invention is explained.

A color filter layer 3 is formed on the solid-state imaging device substrate 1. The color filter layer 3 includes several kinds of color filters 3a-3c positioned at predetermined areas of the transparent material 3d so that the color filters 3a-3c correspond to the light sensing parts 2. On the color filter layer 3, a transparent material layer 4 and photosensitive material layer patterns 12 are formed continuously.

In this invention, a photosensitive material layer pattern 12 and a transparent material 4 formed just beneath the pattern 12 function as a substantial microlens. The microlens is formed in a semicircular or nearly semicircular sectional shape (i.e. a substantial hemisphere shape). Further, in accordance with the invention, a microlens is formed so as to contact the lower periphery with the lower periphery of the adjacent microlens as shown in Fig. 1.

In this structure, the light focused by the microlenses passes through the color filter layer 3, and is separated into colors to enter the light sensing parts 2. As a result, a color pictorial image of an excellent light sensitivity is obtained. This is because the microlens is formed so as to contact the lower periphery with that of the adjacent one without separating independently, so that the light entering the solid-state imaging device may be focused without waste, thereby realizing the solid-state imaging device of an excellent light sensitivity.

In Figs 2 to 8, the manufacturing method of the solid-state imaging device in the embodiment of the invention is described in the sequence of the steps.

In Fig. 2, a color filter layer 3 is formed on the solid-state imaging device substrate 1, and the surface is planarizated by the method described in the parent application, No. 9301937.6. In Fig. 3, a transparent material layer 4 is formed and baked to form a first layer. Sequentially, in Fig. 4, a photosensitive material layer 6 is applied in a desired thickness on the first layer composed of the transparent material layer 4 formed in Fig. 3, and is baked at about 110°C so as not to disturb the photosensitive property of the photosensitive material layer 6, thereby forming a second layer. In Fig. 5, next, the second layer made of the photosensitive material layer 6 is selectively exposed by using a mask, and developed, and rinsed, and the photosensitive material layer 6 is patterned, thereby obtaining a photosensitive material layer pattern 7. Then, the photosensitive material layer pattern 7 is fully exposed by the light in the wavelength in the ultraviolet region, and the transmissivity of the visible light region is raised over 90%. The transmissivity must be raised as far as possible because it is not desired if the sensitivity is lowered due to lowering of the transmissivity. As a result, the photosensitive material layer pattern 7 changes to the photosensitive material pattern 11 raised in the transmissivity as shown in Fig. 6. In succession, the photosensitive material layer pattern 11 raised in the transmissivity by full exposure is heated over 150°C. Fig. 7 shows the melted and fluidized state of the photosensitive material layer pattern 11 raised in the transmissivity, and at this step, the microlens shape with a semicircular or nearly semicircular sectional shape is almost completed. In the state of Fig. 7, however, the photosensitive material layer patterns 12 in semicircular or nearly semicircular sectional shape are separate and independent from each other. Then, in Fig. 8, the first layer of the transparent material layer 4 is selectively exposed by using a mask (not shown), and developed, and rinsed, and is removed in a V-shaped groove in the sectional direction between adjacent patterns 12. By adjusting the resolution and exposure focus of the transparent material, the V-shaped groove may be easily formed. As the method of removing, aside from the selective exposure using a mask mentioned above, it is also possible to remove, needless to say, by dry etching such as O₂ ashing, and wet etching using chemical solution. As a result, microlens 10 made of a transparent material layer 4 and photosensitive material pattern 12 is obtained as shown in Fig. 8.

In this state, the microlens 10 has a semicircular or nearly semicircular sectional shape (i.e. a substantial hemisphere shape), and plural microlenses 10 are formed continuously without separating from each other. In other words, the lower periphery of a microlens 10 is contact with that of the adjacent one, so that the light entering the solid-state imaging device may be focused without waste, thereby realizing the solid-state imaging device of an excellent light sensitivity.

The thickness of the transparent material layer 4 is not particularly specified as far as within the thickness of the intended microlens 10, but excessively thick coating must be avoided because the distance form the light sensing parts to the microlens 10 becomes long, which may lead to deterioration of characteristics such as lowering of light sensitivity.

The material of the transparent material layer 4 may be a transparent material such as copolymer of PGMA (polyglycidyl methacrylate) and PMMA (polymethyl methacrylate) being positive type resists of far ultraviolet ray photosensitive type, which can be etched by O₂ ashing or other method, and the transmissivity in the visible ray wavelength region may be 90% or more. As the material for the photosensitive material layer 6, a phenol type positive resist using naphthoquinone diazide as the photosensitive group may be listed. But any material may be used as far as the following conditions are satisfied.
(i) A fine pattern can be formed by selective exposure using mask.
(ii) The transmissivity in the visible ray region is 90% or more.
(iii) The same transmissivity can be obtained by material transparent treatment by irradiation with ultraviolet rays.
(iv) Shape changing by thermoplasticity and shape fixing by thermal curing may be promoted nearly simultaneously by heat treatment to determine the shape by the difference of the progress of these two.
(v) The reliabilities of gas resistance, chemical resistance and others are excellent.

As the material for the etching resistant material layer 9, any material may be used as far as affinity for the transparent material layer 4 is superior, the transmissivity in the visible ray region is 90% or more, and the resistance to dry etching such as O₂ ashing and wet etching is excellent. For example, the material for forming the photosensitive material layer 6 used for forming the microlens 5 is resistant to O₂ ashing after heat curing, and satisfies the other conditions and is hence usable.

This embodiment relates to the case of using color filter, but the manufacturing method of the solid-state imaging device of the invention may be applicable, needless to say, also to the case of using only black filter used in shielding light, instead of the color filter.

In the solid-state imaging device and its manufacturing method according to the embodiment, in which the transparent material layer and photosensitive material layer are laminated at positions corresponding to the light sensing parts on the color filter layer, and microlenses are formed continuously in a substantial hemisphere shape so as to contact the lower periphery with that of adjacent one, the light can be focused very efficiently in the light sensing parts of the solid-state imaging device substrate, and by using the transparent material layer in the lower layer as a part of microlenses, the space between microlenses is eliminated to be present continuously, so that the ineffective light is reduced and the light sensitivity is enhanced. Besides, because of being focused, the solid-state imaging free from scattering or mixing of light in the adjacent light sensing parts may be realized.

## Claims

1. A solid-state imaging device comprising a plurality of microlenses formed continuously on a filter layer (3) on a solid-state imaging device substrate (1), being composed of a bottom transparent material layer (4) and a top photo-sensitive material layer (12), each microlens having a substantially hemispherical shape and contacting with its lower periphery the lower periphery of the adjacent microlens.

2. A method of manufacturing a solid-state imaging device according to Claim 1, comprising a step of forming a first layer by forming a transparent material layer (4) on a filter layer (3) formed on a solid-state imaging device substrate (1), a step of forming a second layer of a photosensitive material layer (6) on the first layer, and selectively exposing said second layer so as to form a pattern (7), a step of fully exposing the patterned photosensitive material layer to increase its transmissivity for visible light, a step of forming microlens patterns by heating the patterned photosensitive material layer after full exposure, and forming a V-groove in the sectional direction by removing the parts of the first layer made of transparent material layer existing between adjacent microlens patterns.

## Patentansprüche

1. Festkörper-Bildaufnahmeeinrichtung, die eine Vielzahl von Mikrolinsen umfasst, die auf einer Filterschicht (3) auf einem Substrat (1) einer Festkörper-Bildaufnahmeeinrichtung kontinuierlich ausgebildet und aus einer unteren Schicht (4) aus transparentem Material und einer oberen Schicht (12) aus fotoempfindlichem Material zusammengesetzt sind, wobei jede Mikrolinse eine im Wesentlichen halbkugelartige Form hat und an ihrem unteren Umfang mit dem unteren Umfang der benachbarten Mikrolinse in Kontakt ist.

2. Verfahren zum Herstellen einer Festkörper-Bildaufnahmeeinrichtung nach Anspruch 1, die einen Schritt des Ausbildens einer ersten Schicht durch Ausbilden einer Schicht (4) aus transparentem Material auf einer Filterschicht (3), die auf einem Substrat (1) einer Festkörper-Bildaufnahmeeinrichtung ausgebildet ist, einen Schritt des Ausbildens einer zweiten Schicht aus einer Schicht (6) aus fotoempfindlichem Material auf der ersten Schicht und des selektiven Belichtens der zweiten Schicht, um eine Struktur (7) herzustellen, einen Schritt des vollständigen Belichtens der strukturierten Schicht aus fotoempfindlichem Material, um ihre Durchsichtigkeit für sichtbares Licht zu erhöhen, einen Schritt des Ausbildens von Mikrolinsen-Strukturen durch Erhitzen der strukturierten Schicht aus fotoempfindlichem Material nach dem vollständigen Belichten und des Ausbildens einer V-Nut in der Querschnittsrichtung durch Entfernen der Teile der ersten Schicht, die aus der Schicht aus transparentem Material bestehen, die zwischen benachbarten Mikrolinsen-Strukturen vorhanden sind, umfasst.

## Revendications

1. Dispositif imageur à état solide, comprenant une pluralité de microlentilles qui sont formées de manière continue sur une couche formant filtre (3) qui est présente sur un substrat de dispositif imageur à état solide (1), dont la composition est formée d'une couche de matière transparente (4) présente à la partie inférieure et d'une couche de matière photosensible (12) présente à la partie supérieure, chaque microlentille ayant une forme sensiblement hémisphérique et étant en contact, par sa périphérie inférieure, avec la périphérie inférieure de la microlentille adjacente.

2. Procédé de fabrication d'un dispositif imageur à état solide tel que défini dans la revendication 1, comprenant une étape qui consiste à former une première couche en formant une couche de matière transparente (4) sur une couche formant filtre (3) qui est formée sur un substrat de dispositif imageur à état solide (1), une étape qui consiste à former une deuxième couche faite d'une couche de matière photosensible (6) sur la première couche, et à exposer sélectivement ladite deuxième couche de façon à former un motif (7), une étape qui consiste à exposer complètement la couche de matière photosensible ayant subi le tracé de motif de façon à augmenter son coefficient de transmission pour la lumière visible, une étape qui consiste à former des motifs de microlentilles en chauffant la couche de matière photosensible ayant subi le tracé de motif après l'exposition complète, et à former une rainure en V suivant la direction de coupe en retirant les parties de la première couche faite de la couche de matière transparente qui existent entre les motifs de microlentilles adjacentes.
